# EUROPEAN PATENT APPLICATION

(11) **EP 4 712 752 A1**
(43) Date of publication of application: **18.03.2026**
(21) Application number: 25195927.6
(22) Date of filing: 14.08.2025
(51) Int. Cl.: H10N 70/20

(54) **MULTILEVEL VARIABLE PHASE CHANGE MEMORY DEVICE AND MANUFACTURING METHOD THEREOF**

(30) Priority: 22.08.2024 KR 20240112490; 31.10.2024 KR 20240152048
(71) Applicant: Korea University Research and Business Foundation, Seoul 02841 (KR)
(72) Inventor: Kim, Taegeun, 13568 Seongnam-si, Gyeonggi-do (KR); Choi, Junyoung, 05351 Seoul (KR)
(74) Representative: Jung, Minkyu

(57) **Abstract**

A memory device that includes both a heat diffusion facilitating layer and a heat diffusion inhibiting layer is disclosed. A phase change memory device according to an embodiment disclosed herein includes: a first phase change layer; a first heat diffusion facilitating layer disposed to be adjacent to one surface of the first phase change layer; and a first heat diffusion inhibiting layer disposed to be adjacent to the other surface of the first phase change layer.

## Description

### CROSS-REFERENCE TO RELATED PATENT APPLICATION

This application claims the benefit of Korean Patent Application No. 10-2024-0152048, filed on Oct. 31, 2024, in the Korean Intellectual Property Office, the disclosure of which is incorporated herein in its entirety by reference.

### TECHNICAL FIELD

The present disclosure relates to a multi-level variable phase change memory device, and more particularly, to a memory device including both a heat diffusion facilitating layer and a heat diffusion inhibiting layer.

### STATEMENT REGARDING GOVERNMENT SPONSORED RESEARCH OR DEVELOPMENT

The present disclosure was derived from research conducted as part of Next-Generation Intelligent Semiconductor Technology Development of the Ministry of Science and ICT (Project Identification No.: 2710069358, Sub-Project No.: 00407199, Research Project Title: Development of Ultra-Low-Power, High-Performance Phase Change Memory/Memristor Device Based on Heterostructure through Heat Diffusion Control, Institute of Organization: Korea University Industry-Academic Cooperation Foundation, Research Period: March 01, 2024 to December 31, 2026).

There is no property interest of the Korean government in any aspect of this disclosure.

### BACKGROUND

A phase change random access memory (PRAM) is a significant evolution of a non-volatile memory and is an innovative memory that combines a non-volatile property of Not AND (NAND) Flash with fast switching speed of dynamic random access memory (DRAM). In the PRAM, a phase change material between a top electrode and a bottom electrode is used as a switching layer to write a logic "0" or "1" in each memory cell. The phase change material provides high reproducibility and non-volatility, and stores and reads information using a difference in electrical conductivity between an amorphous (high resistance, RESET) state and a crystalline (low resistance, SET) state.

In current PRAM technology, a Ge-Sb-Te (GST) ternary chalcogenide material is mainly used to form a phase change layer, and the GST has a fast phase change property and a large resistance difference, and thus it is suitable for the switching layer of the PRAM. However, the GST has a problem of high melting temperature and power consumption, and a problem of resistance drift according to repeated operation, and research of various approaches has been conducted in recent studies to solve these problems.

### SUMMARY

### TECHNICAL PROBLEM

An object of the present disclosure is directed to providing a memory device including both a heat diffusion facilitating layer and a heat diffusion inhibiting layer.

### TECHNICAL SOLUTION

A phase change memory device according to an embodiment may include: a first phase change layer; a first heat diffusion facilitating layer disposed to be adjacent to one surface of the first phase change layer; and a first heat diffusion inhibiting layer disposed to be adjacent to the other surface of the first phase change layer.

Here, the phase change memory device may further include a bottom electrode disposed at a bottom of the first phase change layer, and a top electrode disposed on a top of the first phase change layer.

Here, the phase change memory device may further include a second phase change layer disposed to be adjacent to the first heat diffusion facilitating layer, a second heat diffusion facilitating layer disposed to be adjacent to the second phase change layer, a third phase change layer disposed to be adjacent to the first heat diffusion inhibiting layer, and a second heat diffusion inhibiting layer disposed to be adjacent to the third phase change layer.

Here, the bottom electrode may be disposed to be adjacent to the second heat diffusion facilitating layer.

Here, the phase change memory device may further include a second phase change layer disposed to be adjacent to the first heat diffusion facilitating layer, wherein the bottom electrode may be disposed to be adjacent to the second phase change layer.

Here, the phase change memory device may further include a second phase change layer disposed to be adjacent to the first heat diffusion facilitating layer, a second heat diffusion inhibiting layer disposed to be adjacent to the second phase change layer, a third phase change layer disposed to be adjacent to the first heat diffusion inhibiting layer, and a second heat diffusion facilitating layer disposed to be adjacent to the third phase change layer.

Here, an area in which the bottom electrode is in contact with an adjacent layer may be smaller than an area in which the top electrode is in contact with an adjacent layer.

Here, a thickness of the top electrode may be smaller than a thickness of the bottom electrode.

Here, a thickness of the first heat diffusion facilitating layer and the first heat diffusion inhibiting layer may be smaller than a thickness of the first phase change layer.

Here, a phase change material included in the first phase change layer may include at least one of Ge-Sb-Te (GST), Sb2Te3, GeSe, GeTe, and a chalcogenide material.

Here, the first heat diffusion facilitating layer may include at least one of TiTe2 and NiTe2.

Here, the first heat diffusion inhibiting layer may include at least one of MoTe2 and HfTe2.

A phase change memory device according to another embodiment may include: a plurality of phase change layers; a plurality of heat diffusion facilitating layers; and a plurality of heat diffusion inhibiting layers, wherein the plurality of heat diffusion facilitating layers and the plurality of heat diffusion inhibiting layers may be disposed according to a predetermined rule, and a third layer included in the plurality of phase change layers may disposed between a first layer and a second layer which are included in the plurality of heat diffusion facilitating layers or the plurality of heat diffusion inhibiting layers to prevent them from being in direct contact with each other.

Here, the predetermined rule may be that the plurality of heat diffusion facilitating layers and the plurality of heat diffusion inhibiting layers are disposed alternately with each other.

Here, the predetermined rule may be that the plurality of heat diffusion facilitating layers are disposed N (N is a natural number) times, and then the plurality of heat diffusion inhibiting layers are disposed M (M is a natural number) times in one axial direction.

### ADVANTAGEOUS EFFECTS

According to an embodiment of the present disclosure, it is possible to provide a memory device including both a heat diffusion facilitating layer and a heat diffusion inhibiting layer.

### BRIEF DESCRIPTION OF THE DRAWINGS

FIG. 1 is a view showing a conventional phase change heterostructure (PCH).
FIG. 2 is a view showing a phase change heterostructure according to an embodiment.
FIG. 3 is a view for describing a phase change memory device according to an embodiment.
FIG. 4 is a view for describing a phase change memory device according to another embodiment.
FIG. 5 is a view for describing a phase change memory device according to still another embodiment.
FIG. 6 is a view for describing a phase change memory device according to yet another embodiment.
FIG. 7A is a view showing a Energy Dispersive X-ray Spectroscopy (EDS) image of a phase change memory device.
FIG. 7B is a view showing an atomic arrangement of the phase change memory device.
FIG. 8A is a high-resolution transmission electron microscopy (HRTEM) photograph of a double confined (DC)-PCH cross-sectional structure after a RESET operation of the phase change memory device.
FIG. 8B is a photograph of a field-effect transistor (FET) of a crystalline region of the phase change memory device.
FIG. 8C is an FET photograph of an amorphous region of the phase change memory device.
FIG. 9A is a view showing that joule heat is diffused into a relatively narrow region in the phase change memory device of the embodiment of FIG. 3 when a V1 voltage is applied.
FIG. 9B is a view showing that joule heat is diffused into a relatively wide region in the phase change memory device of the embodiment of FIG. 3 when a V2 voltage is applied.
FIG. 10A is a view showing that joule heat is diffused into a relatively narrow region in the phase change memory device of the embodiment of FIG. 4 when the V1 voltage is applied.
FIG. 10B is a view showing that joule heat is diffused into a relatively wide region in the phase change memory device of the embodiment of FIG. 4 when the V2 voltage is applied.
FIG. 11A is a view for describing diffusion of heat when the voltage of V1 is applied to the phase change memory device of the embodiment of FIG. 5.
FIG. 11B is a view for describing diffusion of heat when the voltage of V2 is applied to the phase change memory device of the embodiment of FIG. 5.
FIG. 12A is a view for describing diffusion of heat when the voltage of V1 is applied to the phase change memory device of the embodiment of FIG. 6.
FIG. 12B is a view for describing diffusion of heat when the voltage of V2 is applied to the phase change memory device of the embodiment of FIG. 6.
FIG. 13A is a view showing a simulated temperature distribution in a RESET (Referred to as Reset)-1 state.
FIG. 13B is a view showing a simulated temperature distribution in a RESET-2 state.
FIG. 13C is a view showing a simulated temperature distribution of a NiTe2-PCH cell in a RESET state at 2V.
FIG. 13D is a view showing the simulated temperature distribution of the NiTe2-PCH cell in the RESET state at 2.5V.
FIG. 13E is a view showing a simulated temperature distribution of a MoTe2-PCH cell.
FIG. 14A is a cross-sectional TEM image of a conventional phase change memory device that is heat-treated at 200 °C.
FIG. 14B is a cross-sectional TEM image of a phase change memory device of the present disclosure that is heat-treated at 200 °C.
FIG. 15A is a cross-sectional TEM image of a conventional phase change memory device that is heat-treated at 250 °C.
FIG. 15B is a cross-sectional TEM image of a phase change memory device of the present disclosure that is heat-treated at 250 °C.

### DETAILED DESCRIPTION OF THE EMBODIMENTS

The embodiments described herein are intended to clearly describe the idea of the present disclosure to those having ordinary skill in the art to which the present disclosure pertains, the present disclosure is not limited to the embodiments described herein, and the scope of the present disclosure should be interpreted to include modified or varied examples that do not depart from the idea of the present disclosure.

The terms used herein have been selected from commonly used terms as much as possible in consideration of their functions in the present disclosure, but these may vary depending on the intention of those having ordinary skill in the art, case law, or emergence of new technologies in the technical field to which the present disclosure pertains. However, in a case where a specific term is used with an arbitrary meaning, the meaning of that term will be described separately. Therefore, the terms used herein should be interpreted based on the actual meaning thereof and the overall content of this specification, rather than simply the name of the terms.

The drawings attached herein are intended to facilitate the description of the present disclosure, and shapes shown in the drawings may be exaggerated as necessary to help understand the present disclosure, and therefore the present disclosure is not limited by the drawings.

When it is deemed that a specific description of a configuration or function of a known matter related to the present disclosure may obscure the gist of the present disclosure, a detailed description thereof will be omitted according to necessity.

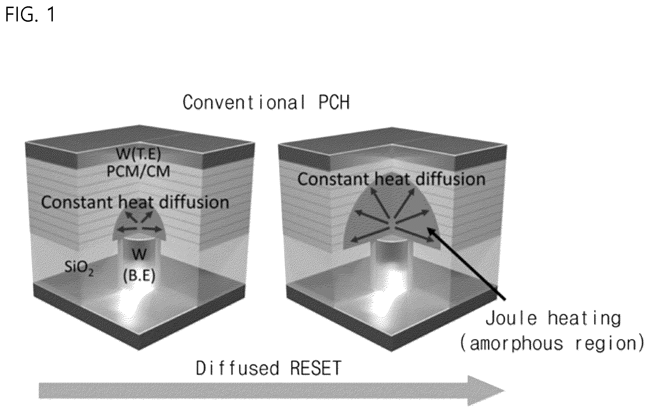

FIG. 1 is a view showing a conventional phase change heterostructure (PCH).

Referring to FIG. 1, the conventional phase change heterostructure is a structure that mainly uses a change in a property of a material without utilizing a diffusion degree of joule heat.

Specifically, it may be confirmed that as heat diffusion of the conventional PCH device is constant, it is difficult to adjust an amorphous region of a phase change material (PCM) layer when voltage is applied.

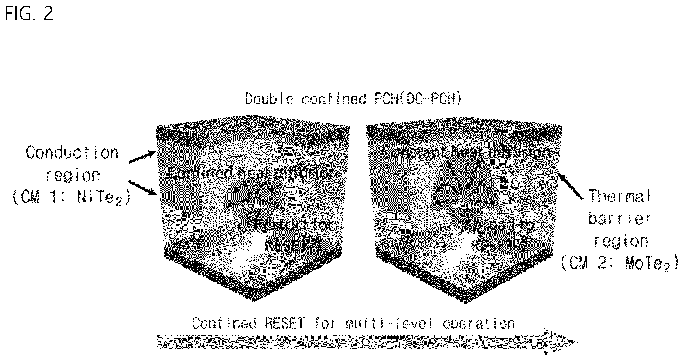

FIG. 2 is a view showing a phase change heterostructure according to an embodiment.

Referring to FIG. 2, it may be confirmed that the phase change heterostructure according to an embodiment of the present disclosure uses two separate transition metal dichalcogenide (TMDC) materials as charge modulation (CM) layers (first CM layer: conductive region, second CM layer: heat blocking region) to prevent heat transfer when voltage is applied unlike the conventional structure of FIG. 1.

The phase change heterostructure according to an embodiment of the present disclosure uses both a heat diffusion facilitating layer and a heat diffusion inhibiting layer. Accordingly, heat diffusion may be reduced and joule heat limitation is improved, thereby increasing power and heat efficiency.

Specifically, the present disclosure relates to a multi-level implementation technology for high integration/low power operation capable of maximizing efficiency of joule heat utilizing a lattice structure and efficiently using an area of a switching layer more suitably than a conventional PRAM by utilizing a temperature control method.

The conventional phase change memory device has been developed by using only one material for the CM layer to maximize an advantage of the material. However, the present disclosure relates to a disclosure that utilizes two materials other than a phase change material as heat diffusion inhibiting and facilitating layers and utilizes their respective properties. Accordingly, in the phase change memory device of the present disclosure, a material with relatively good thermal stability is excellent in thermal resistance. Accordingly, thermal conductivity is good in an in-plane direction of the material or a phonon scattering occurs on a surface thereof.

The present disclosure is a structural approach based on a superlattice structure like the PCH, but it has a significant difference in that a concept of stacking a thermal barrier and a conductive layer together with the phase change material multiple times has been introduced into the PRAM by utilizing materials that affect heat diffusion in addition to a role of the CM layer to prevent atomic diffusion. Here, a region that acts as the thermal barrier is a region inhibiting the heat diffusion from being diffused, and conversely, a region that is relatively conductive is a region with excellent electrical conductivity and thermal conductivity in a cross-plane direction and is capable of effectively transferring the heat diffusion to the phase change material.

Conductivity of the PRAM greatly affects joule heat generated when current is applied to the device. Therefore, the present disclosure utilizes these characteristics and uses a region with excellent conductivity together with the heat diffusion inhibiting layer so as to form joule heat of very high temperature even at a low voltage. In addition, joule heat formed at a bottom electrode is diffused evenly in a direction of a top electrode to facilitate heat diffusion, thereby efficiently using the phase change material.

When the heat diffusion is controlled by forming several layers of the heat diffusion inhibiting layer and the heat diffusion facilitating layer inside the device by utilizing the properties of various materials in this way, it is possible to adjust an amount of heat affecting each phase change layer according to an applied voltage value, thereby inducing a multi-level property according to the applied voltage by inducing distribution of heat according to a change in a phase change area. In addition, a multi-level property with very low reliability is exhibited when going from SET to RESET by a quenching method of the phase change random access memory, but by controlling this with the heat diffusion inhibiting layer, it is possible to secure a bidirectional multi-level property with very high performance compared to a conventional method.

Specifically, when there is a material with low conductivity and good thermal stability, it is very stable against heat, and thus it is possible to secure a device that is outstanding in a durable operation. However, it is also very resistant to heat, and thus it consumes a large amount of power to form joule heat for an operation inside the device. Conversely, when an excellent conductive material is used, the stability against heat may be poor, and thus it may not be suitable for a durable operation. However, high temperature joule heat may be formed even with low power consumption, and thus it is possible to secure a device that is excellent for power operation.

A structure of the phase change memory device of the present disclosure may implement a high-performance multi-level operation by utilizing the two properties. A material with relatively good thermal stability has excellent thermal resistance. Accordingly, thermal conductivity is good in the in-plane direction of the material, or the phonon scattering occurs on the surface thereof. By utilizing this, the concept of the thermal barrier was introduced into the PRAM so that only a specific phase change material is affected by joule heat to inhibit heat diffusion.

Conversely, a material with relatively good conductivity has excellent electrical and thermal conductivity in the cross-plane direction. This greatly affects joule heat generated when current flows through the device, and when the material has excellent conductivity, the conductivity increases throughout the entire structure, high resistance is exhibited in the bottom electrode part even at a low voltage, thereby forming joule heat of very high-temperature even at the low voltage. High thermal conductivity not only forms the joule heat of high-temperature, but also effectively transfers heat generated at the bottom electrode to the top electrode to use the phase change material more widely, thereby enabling low-power operation and fast switching.

Unlike the related art, the phase change memory device of the present disclosure including the heat diffusion control layer may secure not only many high-performance resistance states in a SET state, but also many high-performance resistance states in the RESET state by controlling a degree of heat transfer according to voltage.

Hereinafter, the phase change memory device including both the heat diffusion facilitating layer and the heat diffusion inhibiting layer that may be implemented into various embodiments will be described in detail.

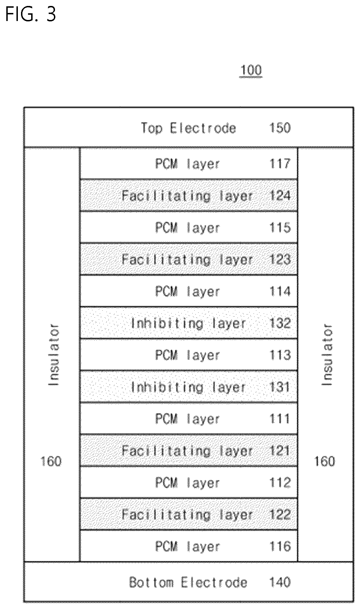

FIG. 3 is a view for describing a phase change memory device according to an embodiment.

Referring to FIG. 3, a phase change memory device 100 according to an embodiment may include a plurality of phase change layers (PCM layers), a plurality of heat diffusion facilitating layers, and a plurality of heat diffusion inhibiting layers. Specifically, the phase change memory device 100 may include a first phase change layer 111, a second phase change layer 112, a third phase change layer 113, a first heat diffusion facilitating layer 121, a second heat diffusion facilitating layer 122, a first heat diffusion inhibiting layer 131, and a second heat diffusion inhibiting layer 132. In addition, the phase change memory device 100 according to an embodiment may further include a bottom electrode 140, a top electrode 150, and an insulator 160 and may further include other components in addition to the above-mentioned components.

The conventional phase change memory device includes only the phase change layer and the heat diffusion facilitating layer, and thus heat diffusion thereof was constant. However, the phase change memory device of the present disclosure includes both the heat diffusion facilitating layer and the heat diffusion inhibiting layer, and thus heat diffusion increases in some regions and heat diffusion decreases in some regions, thereby limiting joule heat and improving power and thermal efficiency. Specifically, when both the heat diffusion facilitating layer and the heat diffusion inhibiting layer are used, a desired heat amount may be transferred to a layered phase change region. In addition, a structural change may be possible by adjusting a number and disposition relationship of the heat diffusion facilitating layer and the heat diffusion inhibiting layer according to an amount of resistance change required in the phase change memory device.

A plurality of layers included in the phase change memory device 100 may be deposited using a deposition method such as electron beam evaporation, thermal evaporation, sputtering system, and atomic layer deposition.

The plurality of phase change layers may receive heat by applying voltage by the bottom electrode 140. When the plurality of phase change layers receive the heat, some of the layers may be phase-changed from a crystalline state to an amorphous state. Some of layers that changed to the amorphous state may be amorphous regions. A phase change material included in the plurality of phase change layers may include at least one of Ge-Sb-Te (GST), Sb2Te3, GeSe, GeTe, and a chalcogenide material, but it is not limited thereto.

The first phase change layer 111 may be disposed in one region of several layers included in the phase change memory device 100. The first heat diffusion facilitating layer 121 may be disposed so that one surface of the first phase change layer 111 is adjacent to the first heat diffusion facilitating layer 121. In an example of FIG 3, a lower surface of the first phase change layer 111 may be adjacent to the first heat diffusion facilitating layer 121.

In addition, the other surface of the first phase change layer 111 may be disposed to be adjacent to the first heat diffusion inhibiting layer 131. In the example of FIG. 3, an upper surface of the first phase change layer 111 may be adjacent to the first heat diffusion inhibiting layer 131. FIG. 3 shows an example in which the first heat diffusion facilitating layer 121 is disposed under the first phase change layer 111 and the first heat diffusion inhibiting layer 131 is disposed on the first phase change layer 111, but it is not limited thereto and an opposite case is also possible.

The heat diffusion facilitating layer included in the phase change memory device 100 may include at least one of TiTe2 and NiTe2 to facilitate heat diffusion, but it is not limited thereto. In addition, the heat diffusion inhibiting layer included in the phase change memory device 100 may include at least one of MoTe2 and HfTe2 to inhibit heat diffusion, but it is not limited thereto.

In addition to the above example, the heat diffusion facilitating layer and the heat diffusion inhibiting layer may commonly include a material with a higher melting point, higher hardness (layered structure), and a smaller lattice constant than the phase change material. In addition, the heat diffusion facilitating layer and the heat diffusion inhibiting layer have CMOS compatibility, and may include a material that is similar in electrical resistance and crystallinity to those of the phase change material, low in chemical reactivity, and has low bonding strength to the phase change material.

In addition, the heat diffusion facilitating layer may include a material with high conductivity, low lattice constant difference, and low phonon scattering. Conversely, the heat diffusion inhibiting layer may include a material with low conductivity, high thermal resistance and thermal stability, and high phonon scattering.

In addition, the second phase change layer 112 may be adjacent to one surface of the first heat diffusion facilitating layer 121. The second heat diffusion facilitating layer 122 may be adjacent to one surface of the second phase change layer 112. Accordingly, the first heat diffusion facilitating layer 121, the second phase change layer 112, and the second heat diffusion facilitating layer 122 may be sequentially disposed below the first phase change layer 111, but it is not limited thereto, and may also be disposed above the first phase change layer 111.

In addition, the third phase change layer 113 may be adjacent to one surface of the first heat diffusion inhibiting layer 131. The second heat diffusion inhibiting layer 132 may be adjacent to one surface of the third phase change layer 113. Accordingly, the first heat diffusion inhibiting layer 131, the third phase change layer 113, and the second heat diffusion inhibiting layer 132 may be sequentially disposed above the first phase change layer 111, but it is not limited thereto, and may also be disposed below the first phase change layer 111.

The plurality of heat diffusion facilitating layers and the plurality of heat diffusion inhibiting layers included in the phase change memory device 100 according to an embodiment of the present disclosure may be disposed according to a predetermined rule. However, the phase change layer may be disposed between the heat diffusion facilitating layer and the heat diffusion inhibiting layer to prevent them from being in direct contact with each other.

In the example of FIG. 3, the heat diffusion inhibiting layer and the heat diffusion facilitating layer may be disposed alternately in pairs, and the phase change layer may be disposed therebetween. That is, in the example of FIG. 3, the predetermined rule may be that the heat diffusion inhibiting layer and the heat diffusion facilitating layer are disposed alternately in pairs. Accordingly, a fourth phase change layer 114 may be adjacent to one surface of the second heat diffusion inhibiting layer 132. A third heat diffusion facilitating layer 123 may be disposed on one surface of the fourth phase change layer 114. A fifth phase change layer 115 may be disposed on one surface of the third heat diffusion facilitating layer 123. A fourth heat diffusion facilitating layer 124 may be disposed on one surface of the fifth phase change layer 115.

Accordingly, the heat diffusion facilitating layer and the heat diffusion inhibiting layer may be disposed alternately in pairs based on the bottom electrode 140, and the phase change layer may be disposed between the heat diffusion facilitating layer and the heat diffusion inhibiting layer so that they are not in direct contact with each other. In addition, the example of FIG. 3 shows that the heat diffusion facilitating layer and the heat diffusion inhibiting layer are disposed alternately in pairs, but it is not limited thereto, and a number of alternating layers may vary, such as one, three, four, or five.

Alternatively, the predetermined rule may be that the plurality of heat diffusion facilitating layers are disposed N (N is a natural number) times, and then the plurality of heat diffusion inhibiting layers are disposed M (M is a natural number) times in one axial direction. In this case, the phase change layer may be disposed between the heat diffusion facilitating layer and the heat diffusion inhibiting layer so that they are not in direct contact with each other. In addition, in this case, N and M may be equal, N may be larger than M, or M may be larger than N.

The phase change memory device 100 may include the bottom electrode 140 disposed at a bottom of a plurality of layers, the top electrode 150 disposed on a top of the plurality of layers, and the insulator 160. A layer in contact with the bottom electrode 140 and the top electrode 150 may be the phase change layer or the heat diffusion facilitating layer. The example of FIG. 3 shows that the layer that is in contact with the bottom electrode 140 and the top electrode 150 is the phase change layer, but it is not limited thereto. In addition, a thickness of the phase change layer included in the phase change memory device 100 may be greater than a thickness of the heat diffusion facilitating layer and the heat diffusion inhibiting layer.

The insulator 160 may be disposed to be adjacent to the bottom electrode 140, the top electrode 150, and the plurality of layers. Accordingly, an electrical connection of a part in which the insulator 160 is in contact may be blocked.

In another aspect, referring to FIG. 3, a phase change memory device 100 according to an embodiment may further include a sixth phase change layer 116 and a seventh phase change layer 117.

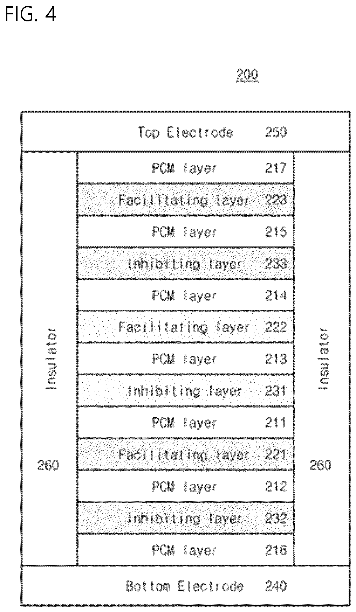

FIG. 4 is a view for describing a phase change memory device according to another embodiment.

Referring to FIG. 4, a phase change memory device 200 according to another embodiment of the present disclosure may include a plurality of phase change layers, a plurality of heat diffusion facilitating layers, and a plurality of heat diffusion inhibiting layers. Specifically, the phase change memory device 200 may include a first phase change layer 211, a second phase change layer 212, a third phase change layer 213, a fourth phase change layer 214, a first heat diffusion facilitating layer 221, a second heat diffusion facilitating layer 222, a third heat diffusion facilitating layer 223, a first heat diffusion inhibiting layer 231, a second heat diffusion inhibiting layer 232, and a third heat diffusion inhibiting layer 233. In addition, the phase change memory device 200 according to another embodiment may further include a bottom electrode 240, a top electrode 250, and an insulator 260 and may further include other components in addition to the above-mentioned components.

The first phase change layer 211 may be disposed in one region of several layers included in the phase change memory device 200. One surface of the first phase change layer 211 may be adjacent to the first heat diffusion facilitating layer 221. In an example of FIG. 4, a lower surface of the first phase change layer 211 may be adjacent to the first heat diffusion facilitating layer 221.

In addition, the other surface of the first phase change layer 211 may be disposed to be adjacent to the first heat diffusion inhibiting layer 231. In the example of FIG. 4, an upper surface of the first phase change layer 211 may be adjacent to the first heat diffusion inhibiting layer 231. FIG. 4 shows an example in which the first heat diffusion facilitating layer 221 is disposed under the first phase change layer 211 and the first heat diffusion inhibiting layer 231 is disposed on the first phase change layer 211, but it is not limited thereto and an opposite case is also possible.

The plurality of heat diffusion facilitating layers and the plurality of heat diffusion inhibiting layers included in the phase change memory device 200 according to an embodiment of the present disclosure may be disposed according to a predetermined rule. However, the phase change layer may be disposed between the heat diffusion facilitating layer and the heat diffusion inhibiting layer to prevent them from being in direct contact with each other.

In the example of FIG. 4, the heat diffusion inhibiting layer and the heat diffusion facilitating layer may be disposed alternately one by one, and the phase change layer may be disposed therebetween. That is, in the example of FIG. 4, the predetermined rule may be that the heat diffusion inhibiting layer and the heat diffusion facilitating layer are disposed alternately one by one. Accordingly, the second phase change layer 212 may be adjacent to one surface of the first heat diffusion facilitating layer 221. In addition, the second heat diffusion inhibiting layer 232 may be adjacent to one surface of the second phase change layer 212.

In addition, the third phase change layer 213 may be adjacent to one surface of the first heat diffusion inhibiting layer 231. In addition, the second heat diffusion facilitating layer 222 may be adjacent to one surface of the third phase change layer 213. Accordingly, the heat diffusion facilitating layer and the heat diffusion inhibiting layer may be disposed alternately one by one based on the bottom electrode 240, and the phase change layer may be disposed between the heat diffusion facilitating layer and the heat diffusion inhibiting layer so that they are not in direct contact with each other.

In another aspect, a phase change memory device 200 according to another embodiment may further include a fifth phase change layer 215, a sixth phase change layer 216, and a seventh phase change layer 217.

Descriptions of the bottom electrode 240, the top electrode 250, and the insulator 260 may be redundant to the content of FIG. 3, so detailed descriptions are omitted.

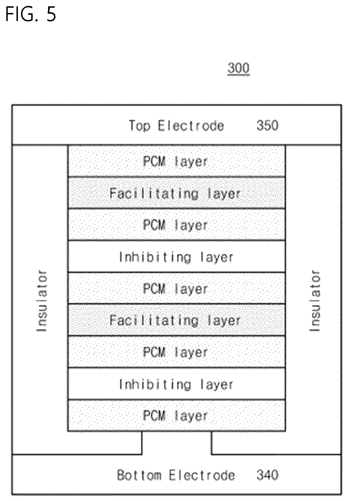

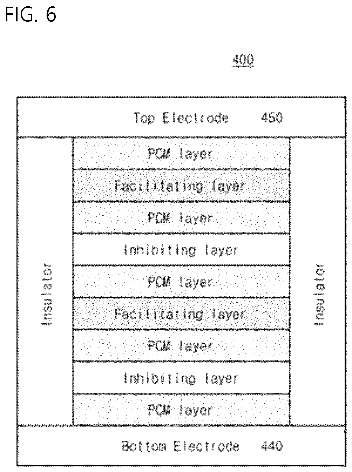

FIG. 5 and FIG. 6 are views for describing a phase change memory device according to still another embodiment. FIG. 5 and FIG. 6 relate to various embodiments of a top electrode or a bottom electrode.

Referring to FIG. 5, a phase change memory device 300 of FIG. 5 has a form different from that of the bottom electrode in the example of FIG. 4. Specifically, an area in which the bottom electrode 340 included in the phase change memory device 300 is in contact with an adjacent layer may be smaller than an area in which the top electrode 350 is in contact with an adjacent layer.

Specifically, since areas in which of the bottom electrode 340 and the top electrode 350 are in contact with plurality of layers are different, self-heating may occur on one surface of the bottom electrode 340. Specifically, self-heating occurs in an electrode with a smaller contact surface of the bottom electrode 340 and the top electrode 350.

Referring to FIG. 6, a phase change memory device 400 of FIG. 6 has a thickness different from that of the bottom electrode in the example of FIG. 4. Specifically, a thickness of the bottom electrode 440 and a thickness of the top electrode 450 included in the phase change memory device 400 may be different from each other. In this case, the thickness of the bottom electrode 440 may be thicker than the thickness of the top electrode 450. Since the thickness of the bottom electrode 440 and the thickness of the top electrode 450 are different, self-heating occurs at the bottom electrode 440.

In an example of FIG. 5, since the area in which each of the bottom electrode 340 and the top electrode 350 is in contact with the plurality of layers is different, artificial joule heat may be generated in an electrode with a small area (bottom electrode in FIG. 5). In addition, in the example of FIG. 6, since the thicknesses of the bottom electrode 440 and the top electrode 450 are different, self-heating may occur inside the device.

Accordingly, in the examples of FIG. 5 and FIG. 6, the phase change memory devices 400, 500 may induce a phase change by efficiently using current to raise temperature of a memory device to a desired value by joule heating or self-heating. In addition, since the phase change memory devices 400, 500 include the heat diffusion inhibiting layer, excessive self-heating may be prevented, thereby minimizing disadvantages of self-heating such as an increase in thermal stress and interference between nearby cells.

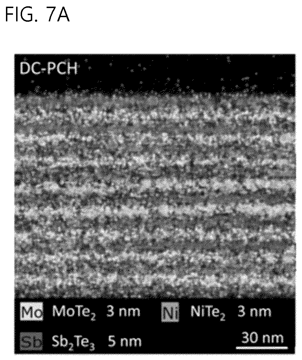

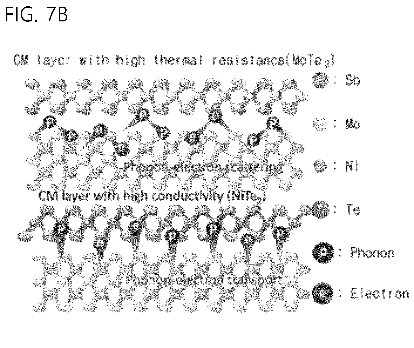

FIG. 7A and FIG. 7B are views for describing a heat diffusion mechanism of the phase change memory device of the present disclosure.

Specifically, FIG. 7A is a view showing a Energy Dispersive X-ray Spectroscopy (EDS) image of a phase change memory device. In addition, FIG. 7B is a view showing an atomic arrangement of the phase change memory device.

Referring to FIG. 7A, in order to implement the phase change memory device of the present disclosure, a conductive metal (CM) layer should be appropriately layered. Specifically, the CM layer should be advantageous for fast switching. In addition, the CM layer should be thermally stable to induce multi-level and longterm effects.

In an example of FIG. 7A, it is shown that the CM layer includes NiTe2 to facilitate heat diffusion and MoTe2 to inhibit heat diffusion, but it is not limited thereto. Referring to FIG. 7B, nickel (Ni) atoms are disposed between tellurium (Te) atoms to form a triangular hierarchical arrangement, and each layer may form a hexagonal arrangement. In addition, since a bond between layers is relatively strong, conductive electrons and phonons may be moved easily, and thus a crystal structure of NiTe2 may be similar to that of Cdl2.

In addition, MoTe2 may be very suitable for a thermal barrier function of PRAM due to a hexagonal 2H crystal structure, strong Mo-Te bonding, weak van der Waals interaction between layers (preventing electron and heat dissipation), high cohesive energy, and excellent phonon scattering capability that enables multi-level switching. Phonon scattering may be used to determine thermal stability as it changes a rate at which heat passes through a material.

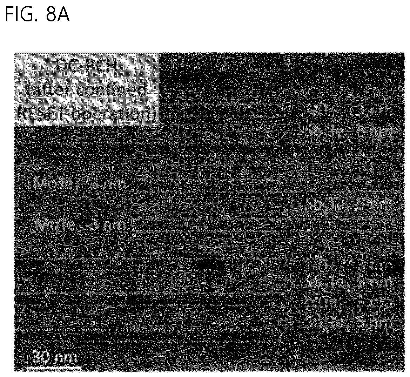

FIGS. 8A to 8C are views showing a high-resolution transmission electron microscopy (HRTEM) image and a field-effect transistor (FFT) image after a RESET operation of the phase change memory device of the present disclosure.

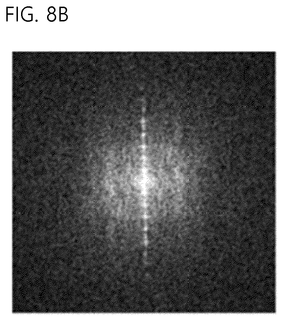

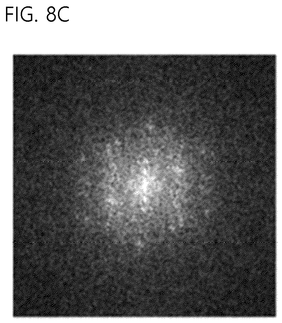

Specifically, FIG. 8A is a HRTEM photograph of a double confined (DC)-PCH cross-sectional structure after the RESET operation of the phase change memory device. FIG. 8B is a photograph of a field-effect transistor (FET) of a crystalline region of the phase change memory device. FIG. 8C is an FET photograph of an amorphous region of the phase change memory device.

Referring to FIG. 8A, generally, high phonon scattering may be related to enhanced thermal stability of a limited MoTe2 layer and limited heat diffusion in a PCM layer. Conversely, high conductivity of a NiTe2 layer may affect electron mobility or density, thereby enabling low-power operation of a device. Therefore, joule heat is used to form an amorphous region, and the amorphous region may be controlled to enable multi-level switching operation when heat is inhibited by including the MoTe2 layer as shown in FIG. 8A.

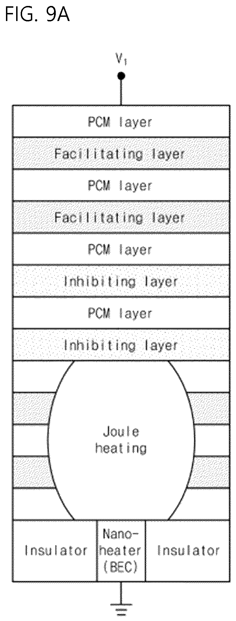

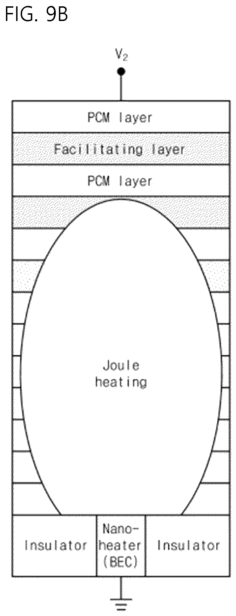

FIG. 9A and FIG. 9B are views for describing that heat is trapped or heat diffusion is facilitated in the phase change memory device of the embodiment of FIG. 3.

Specifically, FIG. 9A is a view showing that joule heat is diffused into a relatively narrow region in the phase change memory device of the embodiment of FIG. 3 when a V1 voltage is applied. In addition, FIG. 9B is a view showing that joule heat is diffused into a relatively wide region in the phase change memory device of the embodiment of FIG. 3 when a V2 voltage is applied.

Referring to FIG. 9A and FIG. 9B, it may be confirmed that joule heat is diffused from a bottom to a top according to an applied voltage. It may be confirmed that joule heat is diffused through the phase change layer and the heat diffusion facilitating layer at the bottom when the V1 voltage is applied, but heat diffusion is inhibited by the heat diffusion inhibiting layer. On the other hand, when the V2 voltage greater than the V1 voltage is applied, joule heat is diffused through the phase change layer and the heat diffusion facilitating layer at the bottom, and joule heat may be diffused beyond the heat diffusion inhibiting layer to the next heat diffusion facilitating layer as the applied voltage is large. Therefore, diffusion of joule heat may be controlled by applying an appropriate voltage depending on an environment and purpose in which the phase change memory device is used.

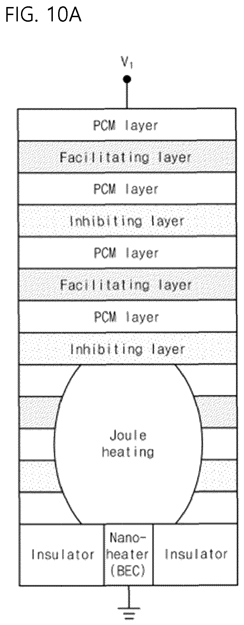

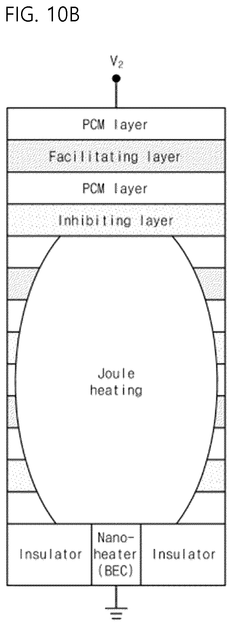

FIG. 10A and FIG. 10B are views for describing that heat is trapped or heat diffusion is facilitated in the phase change memory device of the embodiment of FIG. 4.

Specifically, FIG. 10A is a view showing that joule heat is diffused into a relatively narrow region in the phase change memory device of the embodiment of FIG. 4 when the V1 voltage is applied. In addition, FIG. 10B is a view showing that joule heat is diffused into a relatively wide region in the phase change memory device of the embodiment of FIG. 4 when the V2 voltage is applied.

Referring to FIG. 10A and FIG. 10B, it may be confirmed that joule heat is diffused from a bottom to a top according to an applied voltage. It may be confirmed that joule heat is diffused through the phase change layer and the heat diffusion facilitating layer at the bottom when the V1 voltage is applied, but heat diffusion is inhibited by the heat diffusion inhibiting layer in the middle. On the other hand, when the V2 voltage greater than the V1 voltage is applied, joule heat is diffused through the phase change layer and the heat diffusion facilitating layer at the bottom, and joule heat may be diffused beyond the heat diffusion inhibiting layer to the next heat diffusion facilitating layer as the applied voltage is large. Since the heat diffusion facilitating layer and the heat diffusion inhibiting layer of the phase change memory device 200 of FIG. 4 are disposed alternately one by one compared to the phase change memory device 100 of FIG. 3, a diffusion degree of joule heat may be controlled more precisely.

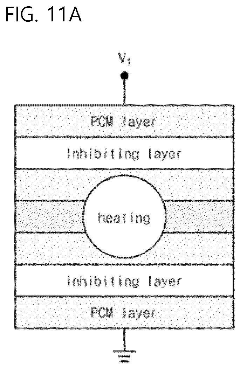

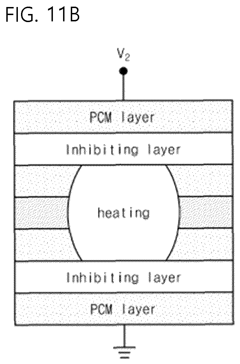

FIG. 11A is a view for describing diffusion of heat when the voltage of V1 is applied to the phase change memory device of the embodiment of FIG. 5, and FIG. 11B is a view for describing diffusion of heat when the voltage of V2 is applied to the phase change memory device of the embodiment of FIG. 5.

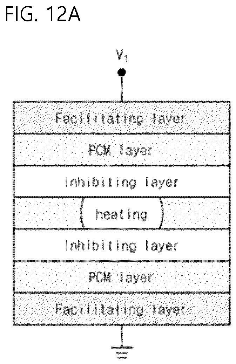

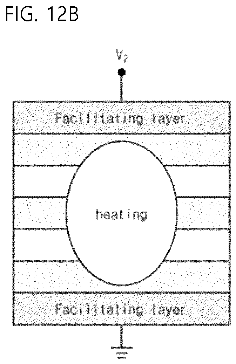

In addition, FIG. 12A is a view for describing diffusion of heat when the voltage of V1 is applied to the phase change memory device of the embodiment of FIG. 6, and FIG. 12B is a view for describing diffusion of heat when the voltage of V2 is applied to the phase change memory device of the embodiment of FIG. 6.

Referring to FIG. 11A, FIG. 11B, FIG. 12A, and FIG. 12B, depending on an arrangement structure of the heat diffusion facilitating layer and the heat diffusion inhibiting layer and a magnitude of the applied voltage, heat may be diffused or trapped at center of the plurality of layers included in the phase change memory device. When configuring heat diffusion inhibiting and heat diffusion facilitating regions in several layers, multi-bit implementation with higher reliability may be possible. This is because heat diffusion may be multi-controlled into several layers.

Referring to FIG. 11A and FIG. 11B, a heat diffusion inhibiting region is divided into two regions based on a heat diffusion facilitating region, which causes a first high resistance state to be formed below the heat diffusion inhibiting region. Thereafter, as heat diffusion is diffused above the inhibiting region by a higher voltage, a second high resistance state may be formed.

Referring to FIG. 12A and FIG. 12B, when the heat diffusion inhibiting and heat diffusion facilitating regions are configured in a layer-by-layer, a larger number of resistance states may be secured, thereby enabling multi-bit implementation capable of various applications. This is because heat diffusion may be controlled in many more forms. A degree of heat diffusion is important for the multi-bit implementation because a phase change material is phase-transitioned by operating heat generated inside thereof. Therefore, the present disclosure may provide the phase change memory device capable of adjusting phase transition through heat diffusion control.

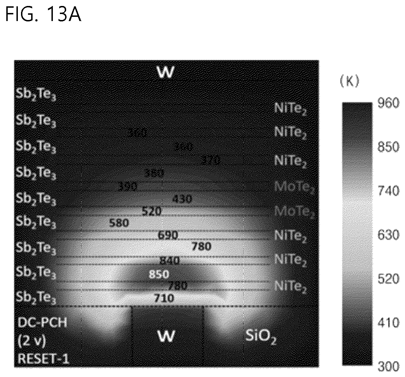

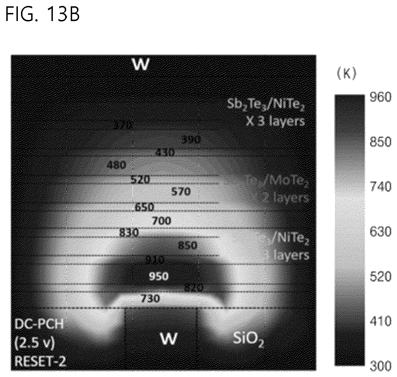

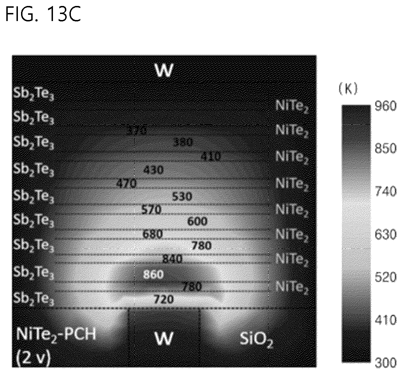

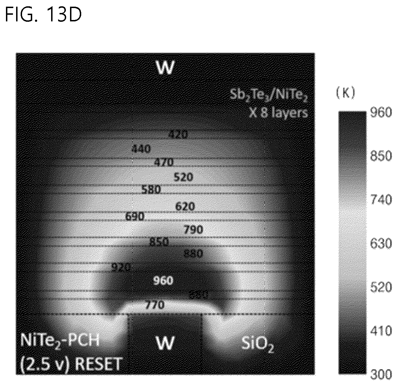

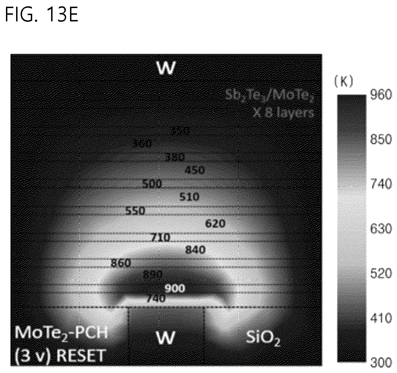

FIGS. 13A to 13E are views for describing an effect of a thermal barrier on joule heating in the phase change memory device of the present disclosure. FIG. 13A is a view showing a simulated temperature distribution in a RESET (Referred to as Reset)-1 state, FIG. 13B is a view showing a simulated temperature distribution in a RESET-2 state, FIG. 13C is a view showing a simulated temperature distribution of a NiTe2-PCH cell in a RESET state at 2V, FIG. 13D is a view showing the simulated temperature distribution of the NiTe2-PCH cell in the RESET state at 2.5V, and FIG. 13E is a view showing a simulated temperature distribution of a MoTe2-PCH cell.

Referring to FIG. 13A and FIG. 13B, in a double confined-PCH (DC-PCH), as MoTe2 has a crystalline structure and a higher cohesive energy (4.04 eV per atom) compared to NiTe2 (3.48 eV per atom), it may act as a thermal barrier that enables multi-level switching. In this case, the DC-PCH may mean redundancy of a conductive region through the thermal barrier.

In addition, by adding a separate partitioning of NiTe2 and MoTe2 to a separate PCM device, an occurrence of temperature distribution that changes gradually stepwise with reduced heat loss is confirmed. This state may be reset when a melting point of a Sb2Te3 layer is reached. Due to a higher electrical conductivity of NiTe2, an initial RESET-1 may occur at a low voltage (2.0 V) and low heat flux in a DC-PCH device. Thereafter, a next voltage further increases and heat is diffused over a MoTe2-based thermal barrier, thereby generating a second RESET-2.

MoTe2 showed higher thermal stability due to its phonon scattering ability, and this means that joule heat of the RESET-2 was stronger and acted as the thermal barrier that hinders long-range atomic diffusion. Accordingly, a resistance difference of two orders of magnitude greater than RESET-1 may occur.

Referring to FIGS. 13C to 13E, results of NiTe2-PCH and MoTe2-PCH based devices may also be confirmed. Since NiTe2 is more conductive than MoTe2, more current may flow in NiTe2 than in MoTe2, thereby generating more heat. However, when conductivity increases, durability and thermal stability may decrease. On the other hand, MoTe2 has excellent self-resistance and thermal resistance due to its excellent phonon scattering property, thereby reducing heat generation and joule heat.

Hereinafter, an experiment comparing an alloy phenomenon of the phase change memory device of the present disclosure with that of a conventional phase change memory device will be described in detail.

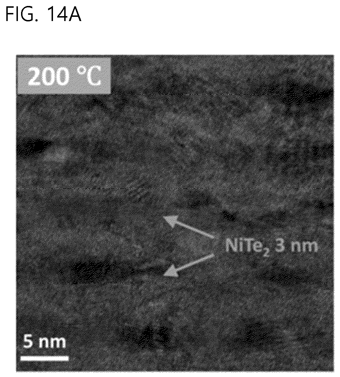

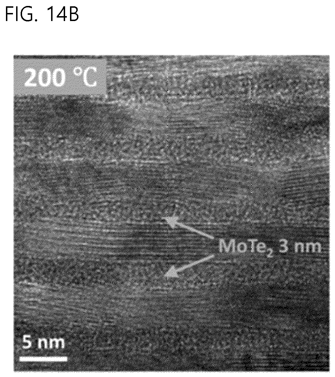

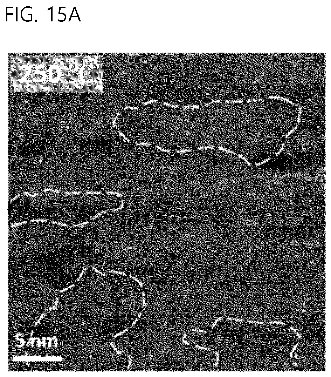

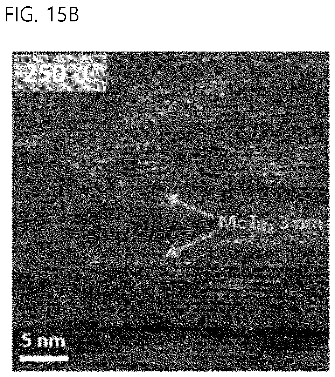

FIG. 14A and FIG. 14B are views for comparing an alloy phenomenon at 200 °C, and FIG. 15A and FIG. 15B are views for comparing an alloy phenomenon at 250 °C.

Specifically, FIG. 14A is a cross-sectional TEM image of a conventional phase change memory device that is heat-treated at 200 °C, and FIG. 14B is a cross-sectional TEM image of the phase change memory device of the present disclosure that is heat-treated at 200 °C.

In addition, FIG. 15A is a cross-sectional TEM image of a conventional phase change memory device that is heat-treated at 250 °C, and FIG. 15B is a cross-sectional TEM image of the phase change memory device of the present disclosure that is heat-treated at 250 °C.

When treated with high heat, materials with high conductivity have low thermal stability due to low cohesion, and thus an alloy phenomenon with the phase change material may occur. However, materials with high thermal stability have low conductivity, but the alloy phenomenon does not occur even in a high-temperature environment.

Referring to FIG. 14A, FIG. 14B and FIG. 15A, FIG. 15B, it may be visually confirmed that the alloy phenomenon occurs in the conventional memory device (FIG. 14A and FIG. 15A), whereas the alloy phenomenon does not occur in the memory device of the present disclosure (FIG. 14B and FIG. 15B).

The present disclosure relates to the memory device which enables multi-bit implementation with high thermal stability by including both the heat diffusion facilitating layer and the heat diffusion inhibiting layer. The phase change memory device of the present disclosure may enable multi-level switching with ultra-low resistance drift. In addition, the memory device of the present disclosure has high thermal stability due to high phonon scattering ability and cohesive energy based on a crystalline structure, thereby enabling higher cycle durability, controlled joule heat, prevention of the alloy phenomenon, and controlling of the amorphous region.

Although the embodiments have been described above by way of limited examples and drawings, those having ordinary skill in the art will appreciate that various modifications and variations can be made from the above description. For example, a suitable result may be achieved even when the described techniques are performed in a different order than described, and/or components of the described systems, structures, devices, circuits, etc. are coupled or combined in a different form than described, or are replaced or substituted by other components or equivalents.

Therefore, other implementations, other embodiments, and equivalents to the claims are also included in the scope of the claims described below.

## Claims

1. A phase change memory device(100, 200, 300, 400) comprising:
a first phase change layer(111, 211);
a first heat diffusion facilitating layer(121, 221) disposed to be adjacent to one surface of the first phase change layer(111, 211); and
a first heat diffusion inhibiting layer(131, 231) disposed to be adjacent to the other surface of the first phase change layer(111, 211).

2. The phase change memory device(100, 200, 300, 400) of claim 1, further comprising a bottom electrode(140, 240) disposed at a bottom of the first phase change layer(111, 211), and
A top electrode(150) disposed on a top of the first phase change layer(111, 211).

3. The phase change memory device(100) of claim 1 or 2, further comprising a second phase change layer(112) disposed to be adjacent to the first heat diffusion facilitating layer(121),
a second heat diffusion facilitating layer(122) disposed to be adjacent to the second phase change layer(112),
a third phase change layer(113) disposed to be adjacent to the first heat diffusion inhibiting layer(131), and
a second heat diffusion inhibiting layer(132) disposed to be adjacent to the third phase change layer(113).

4. The phase change memory device(100) of claim 2 or 3, wherein the bottom electrode(140) is disposed to be adjacent to the second heat diffusion facilitating layer(122).

5. The phase change memory device(100, 200) of claim 2, further comprising a second phase change layer(112, 212) disposed to be adjacent to the first heat diffusion facilitating layer(121, 221),
wherein the bottom electrode(140, 240) is disposed to be adjacent to the second phase change layer(112, 212).

6. The phase change memory device(200) of claim 1 or 2, further comprising a second phase change layer(212) disposed to be adjacent to the first heat diffusion facilitating layer(221),
A second heat diffusion inhibiting layer(232) disposed to be adjacent to the second phase change layer(212),
a third phase change layer(213) disposed to be adjacent to the first heat diffusion inhibiting layer(231), and
a second heat diffusion facilitating layer(222) disposed to be adjacent to the third phase change layer(213).

7. The phase change memory device(300) of any one of claims 2 to 6, wherein an area in which the bottom electrode(340) is in contact with an adjacent layer is smaller than an area in which the top electrode(350) is in contact with an adjacent layer.

8. The phase change memory device(400) of any one of claims 2 to 7, wherein a thickness of the top electrode(450) is smaller than a thickness of the bottom electrode(440).

9. The phase change memory device(100, 200) of any one of claims 1 to 8, wherein a thickness of the first heat diffusion facilitating layer(121, 221) and the first heat diffusion inhibiting layer(131, 231) is smaller than a thickness of the first phase change layer(111, 211).

10. The phase change memory device(100, 200) of any one of claims 1 to 9, wherein a phase change material included in the first phase change layer(111, 211) includes at least one of Ge-Sb-Te (GST), Sb2Te3, GeSe, GeTe, and a chalcogenide material.

11. The phase change memory device(100, 200) of any one of claims 1 to 10, wherein the first heat diffusion facilitating layer(121, 221) includes at least one of TiTe2 and NiTe2.

12. The phase change memory device(100, 200) of any one of claims 1 to 11, wherein the first heat diffusion inhibiting layer(131, 231) includes at least one of MoTe2 and HfTe2.

13. A phase change memory device(100, 200, 300, 400) comprising:
a plurality of phase change layers;
a plurality of heat diffusion facilitating layers; and
a plurality of heat diffusion inhibiting layers,
wherein the plurality of heat diffusion facilitating layers and the plurality of heat diffusion inhibiting layers are disposed according to a predetermined rule, and a third layer included in the plurality of phase change layers is disposed between a first layer and a second layer which are included in the plurality of heat diffusion facilitating layers or the plurality of heat diffusion inhibiting layers to prevent them from being in direct contact with each other.

14. The phase change memory device of claim(200, 300, 400) 13, wherein the predetermined rule is that the plurality of heat diffusion facilitating layers and the plurality of heat diffusion inhibiting layers are disposed alternately with each other.

15. The phase change memory device of claim(100, 200, 300, 400) 13, wherein the predetermined rule is that the plurality of heat diffusion facilitating layers are disposed N (N is a natural number) times, and then the plurality of heat diffusion inhibiting layers are disposed M (M is a natural number) times in one axial direction.
